# EUROPEAN PATENT SPECIFICATION

(11) **EP 4 290 561 B1**
(45) Date of publication and mention of the grant of the patent: **24.12.2025**
(21) Application number: 22759146.8
(22) Date of filing: 14.01.2022
(51) Int. Cl.: H01L 21/673, H01L 21/677

(54) **PURGE DEVICE**
SPÜLVORRICHTUNG
DISPOSITIF DE PURGE

(30) Priority: 24.02.2021 JP 2021027622
(43) Date of publication of application: 13.12.2023
(73) Proprietor: Murata Machinery, Ltd., Kyoto-shi, Kyoto 601-8326 (JP)
(72) Inventor: ITO, Yasuhisa, Ise-shi, Mie 516-0003 (JP)
(74) Representative: Stöckeler, Ferdinand
(86) International application number: PCT/JP2022/001117
(87) International publication number: WO 2022/181103

(56) References cited:
- WO-A1-2019/239672
- JP-A- 2010 182 747
- US-A1- 2014 360 531
- US-A1- 2020 168 488

## Description

### Technical Field

The present disclosure relates to a purge device that is attached to a container placing stand of a storage rack or the like for storing a container, and is configured to supply purge gas to the container.

### Background Art

Conventionally, a storage device (storage rack) is known that receives and stores a container from a vehicle (traveling vehicle) traveling along rails installed on a ceiling. A storage device described in Patent Literature 1 is provided with a purge assembly configured to supply purge gas to the inside of a container.

### Citation List

### Patent Literature

[Patent Literature 1] Japanese Unexamined Patent Publication No. 2015-533026

US 2020/168488 describes a purge device of the prior art.

### Summary of Invention

### Technical Problem

In the conventional storage device described above, a storage rack is equipped with a supply nozzle and a discharge nozzle configured to communicate with the inside of the container. Although not described in the above patent literature, when a container is placed on the storage rack, positioning of the container is required. With the container being positioned, the supply nozzle can be connected to the gas inlet of the container. Therefore, when a purge device is installed in a conveyance system with an overhead transport vehicle, teaching to the overhead transport vehicle is required so that a container is positioned as desired and the supply nozzle is securely connected thereto.

The present disclosure describes a purge device capable of reducing the time and effort of teaching in the conveyance device such as an overhead transport vehicle or the like.

### Solution to Problem

One aspect of the present disclosure is a purge device including a base to which a positioning pin configured to support a container to be purged is attached, and a nozzle configured to be connected to a gas inlet of the container supported by the positioning pin. The purge device includes a nozzle unit having a main body portion attached to the base via the positioning pin, and a gas introduction portion coupled to the main body portion and provided with the nozzle.

With this purge device, the main body portion is attached onto the base by the positioning pin, and the container is positioned and supported by the positioning pin. The gas introduction portion is coupled to the main body portion, and a planar position of the nozzle with respect to the positioning pin is set to fit a position of a corresponding part of a bottom face of the container. As a result, the nozzle of the gas introduction portion is connected to the gas inlet of the container, and purge gas is supplied to the inside of the container through the nozzle. Teaching about the positioning pin is performed for the conveyance device such as the overhead transport vehicle or the like. Once teaching is performed, the position of the positioning pin does not change even if the nozzle unit is replaced for nozzle replacement or other reasons after the teaching. Therefore, teaching is not required again. Consequently, the time and effort required for teaching in the conveyance device such as the overhead transport vehicle or the like can be reduced. This effect can be also exerted at other times than the replacement of the nozzle unit. For example, the same effect as above can be exerted when a purge function is added to a storage rack having no purge function. When the nozzle unit is attached to the storage rack, the main body portion is attached onto the base via the positioning pin, and thus the position of the positioning pin does not change before and after the purging function is added to the storage rack. Therefore, teaching is not required again.

The main body portion may include a flat plate member disposed between the bottom face of the container supported by the positioning pin and the base. With this configuration, a space (gap) existing between the bottom face of the container and the base can be used to dispose the main body portion.

The gas introduction portion may be integrated into the main body portion, and the nozzle may be disposed and fixed in a predetermined position with respect to the positioning pin. With this configuration, installation of the nozzle unit is completed by simply attaching the main body portion to the base. The nozzle unit can be easily installed and the configuration of the nozzle unit is simple.

The gas introduction portion may include an elastic member disposed on an underside of the nozzle to support the nozzle, and the nozzle may be energized upward by the elastic member and be movable up and down. With this configuration, before the container is placed on the positioning pin, the nozzle is energized by the elastic member to be located at an initial position that is slightly elevated. When the container is placed on the positioning pin, the nozzle is pushed downward and comes to close contact with the gas inlet. Thus, adjustment of the position of the nozzle in a height direction can be eliminated.

The gas introduction portion may include a rotary arm that is coupled to the main body portion via a rotary shaft horizontally disposed therebetween and configured to be rotatable with respect to the main body portion. The rotary arm may include a first end provided with the rotary shaft and a second end on a side opposite to the first end, and the nozzle may be provided at the second end. With this configuration, a distance from the rotary shaft to the nozzle corresponds to a length of the rotary arm. A piping for circulating purge gas is connected to the nozzle. Increasing the distance from the rotary shaft to the nozzle can reduce the effect on the piping caused by the rotation of the rotary arm (that is, up and down movement of the nozzle).

### Advantageous Effects of Invention

According to the present disclosure, it is possible to reduce the time and effort for teaching in the conveyance device such as the overhead transport vehicle or the like.

### Brief Description of Drawings

[FIG. 1] FIG. 1 is a diagram illustrating an overall structure of a storage rack provided with a purge device.
[FIG. 2] FIG. 2 is a perspective view illustrating a purge device and a storage rack according to a first embodiment, and an overhead transport vehicle.
[FIG. 3] FIG. 3 is a plan view illustrating the purge device and the storage rack in FIG. 2.
[FIG. 4] FIG. 4(a) is a plan view of the nozzle unit according to the first embodiment, and FIG. 4(b) is a sectional view cut along an IVB-IVB line of FIG. 4(a).
[FIG. 5] FIG. 5 is a sectional view illustrating a configuration of the storage rack before a purge system is added thereto.
[FIG. 6] FIG. 6 is a sectional view illustrating a configuration of the storage rack after the purge function is added thereto.
[FIG. 7] FIG. 7 is a diagram illustrating an arrangement of the gas control device in FIG. 1 in the storage rack.
[FIG. 8] FIG. 8 is a plan view illustrating a purge device and a storage rack according to a second embodiment.
[FIG. 9] FIG. 9(a) is a plan view of the nozzle unit according to the second embodiment, and FIG. 9(b) is a sectional view cut along an IXB-IXB line in FIG. 9(a).
[FIG. 10] FIG. 10 is a sectional view illustrating a configuration of the storage rack after the nozzle unit according to the second embodiment is attached thereto.
[FIG. 11] FIG. 11 is a plan view illustrating a second end of the rotary arm in FIG. 9(a).
[FIG. 12] FIG. 12(a) is a sectional view illustrating an initial position of the second end of the rotary arm, and FIG. 12(b) is a sectional view illustrating an operating position of the second end of the rotary arm.

### Description of Embodiments

An embodiment of the present invention will be described below with reference to the drawings. In description of the drawings, like numerals indicate like components, and overlapping description will be omitted. Terms "X direction," "Y direction," and "Z direction" are based on directions in the drawings and are for convenience only.

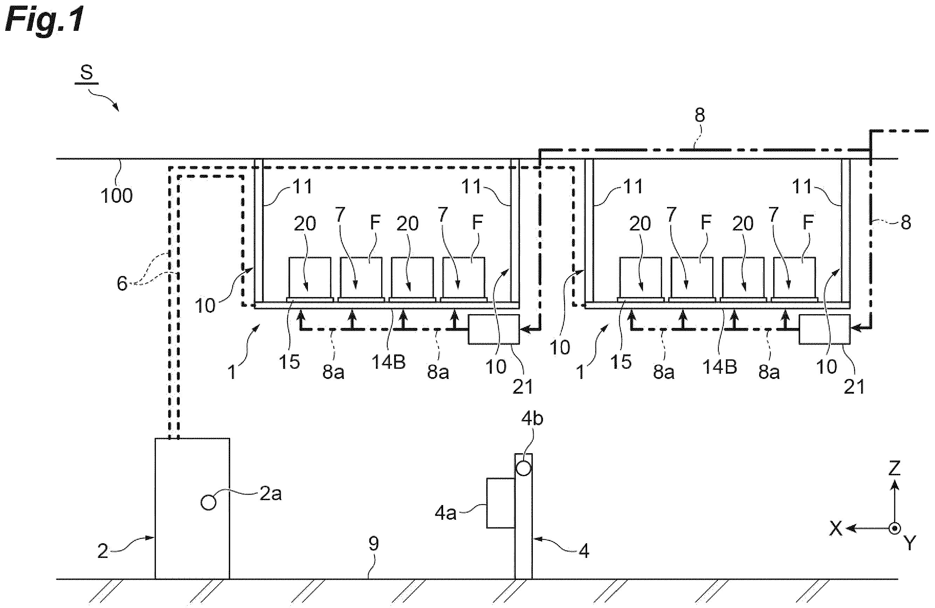

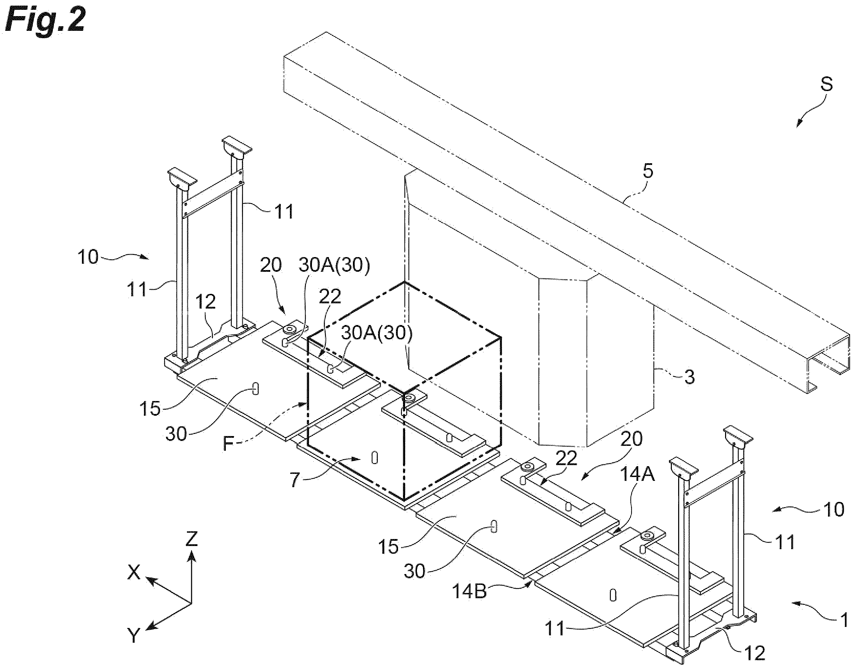

As illustrated in FIGS. 1 and 2, storage racks 1 are disposed along a track 5 of an overhead transport vehicle 3 constituting a semiconductor conveyance system S in a semiconductor manufacturing plant, for example. The storage rack 1 temporarily stores a container F, such as FOUP or a reticle pod. The storage rack 1 is an overhead buffer (OHB). The storage rack 1 may be a side track buffer (STB) disposed on a side of the track 5. The storage rack 1 is configured to purge the interior of the container F with a purge gas (fluid), such as nitrogen.

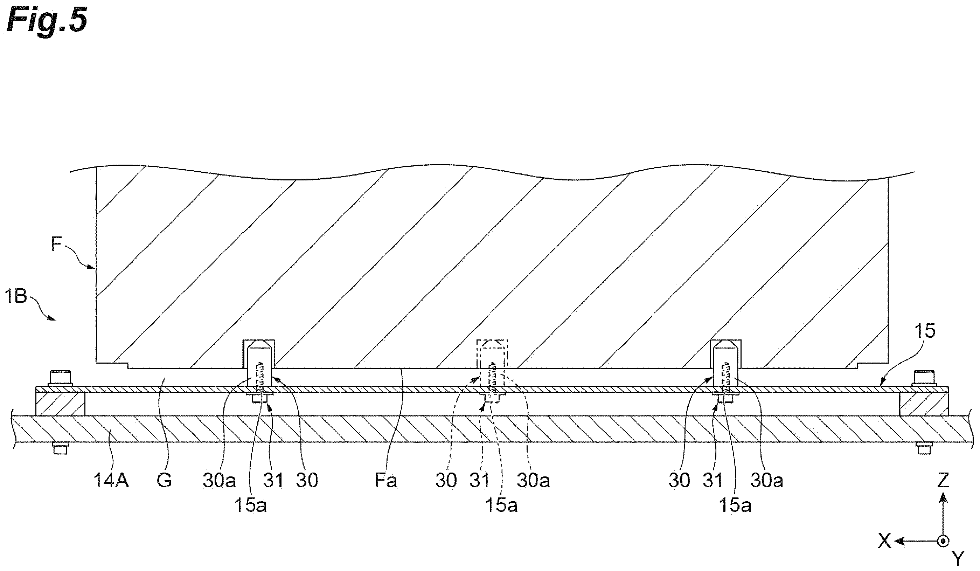

In the following description, as an example, a purge function is added to a storage rack 1B (refer to FIG. 5) that is an existing storage rack having no purge function. A purge device 20 according to the present embodiment is attached to the storage rack 1B having no purging function. In addition to being used for adding a purge function to the storage rack 1B, the purge device 20 can be applied to the storage rack 1 or a load port or the like. For example, when a storage rack 1 is newly installed, the storage rack 1 may be provided with the purge device 20. The purge device 20 may be attached to a storage rack provided with another purge device.

As illustrated in FIG. 1, the semiconductor conveyance system S includes a plurality of the storage racks 1 suspended from a ceiling 100, a distribution panel 2 configured to supply electric power to the storage rack 1 via power supply wiring 6, a monitoring stand 4 configured to monitor oxygen concentration in the plant, and gas supply piping 8 laid on the ceiling 100 and configured to supply purge gas to each of the storage racks 1. Purge gas adjusted to a desired pressure is supplied to the gas supply piping 8. The distribution panel 2 and the monitoring stand 4 are installed, for example, on a floor 9. The distribution panel 2 may be provided with an emergency stop button 2a to stop the supply of the purge gas to the storage rack 1 in an emergency or other circumstances. The monitoring stand 4 is provided with an oxygen concentration sensor 4a. The monitoring stand 4 may be provided with an emergency stop button 4b to stop the supply of purge gas in an event of a drop in oxygen concentration or other circumstances.

As illustrated in FIGS. 1 and 2, each of the storage racks 1 has, for example, two base frames 10 and 10 suspended from the ceiling 100 and two beam members 14A and 14B bridged over the two base frames 10 and 10. Each base frame 10 has, for example, two supporting sections 11 that are suspended from the ceiling 100 and extend in the Z direction that is the vertical direction, and one supporting section 12 that is bridged over the lower ends of the suspension sections 11 and extends in the direction Y that is a horizontal direction. The beam members 14A and 14B are bridged over the two base frames 10 and 10 by being attached to undersides of two supporting sections 12 and 12, which are spaced apart in the X direction, for example.

The beam members 14A and 14B are members made of grooved steel having a C-shaped cross section, for example. The beam members 14A and 14B are not limited to a particular structure and may be angle steel having an L-shaped cross section. The beam members 14A and 14B extend parallel to each other in the X direction that is a horizontal direction and are spaced apart in the Y direction. The beam members 14A and 14B are disposed at equal heights conforming to a position of the overhead transport vehicle 3.

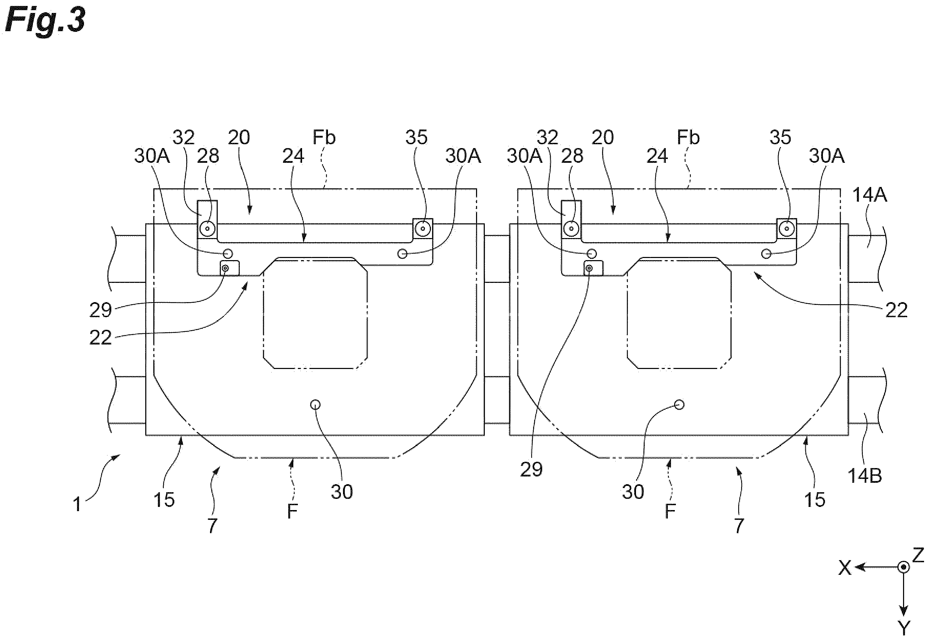

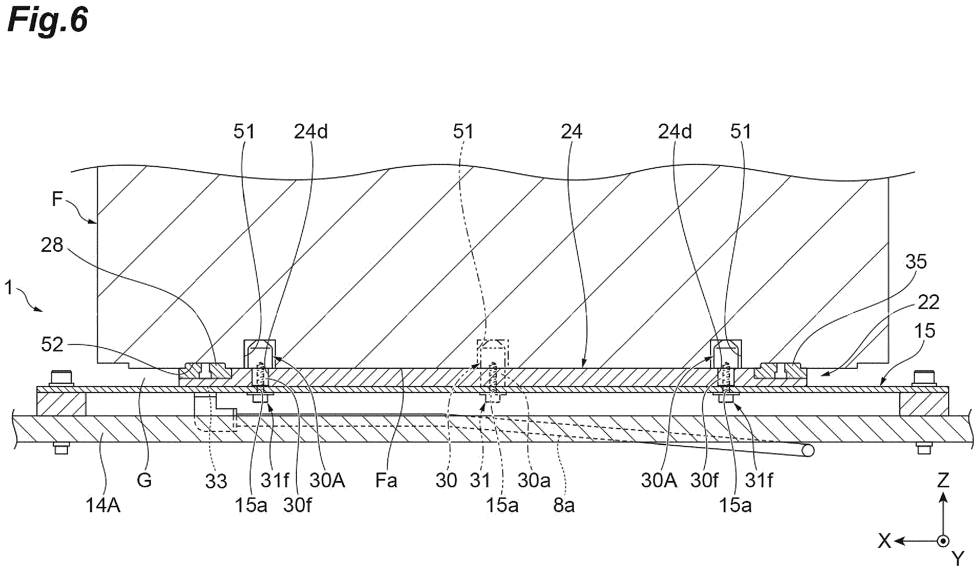

In each storage rack 1, a base 15 of a flat plate shape is attached on the beam members 14A and 14B. The base 15 is, for example, a rectangular plate member having a size substantially the same as a bottom face Fa or somewhat smaller than the bottom face Fa of the container F (refer to FIGS. 5 and 6) in plan view. The base 15 may be larger (longer) than the bottom face Fa in the X direction and smaller (shorter) than the bottom face Fa in the Y direction (see FIG. 3). The base 15 extends horizontally, for example. The base 15 is also called a table. Three positioning pins 30 for positioning the container F are attached on the base 15. For example, two of the positioning pins 30 are located on the beam member 14A and one of the positioning pins 30 is located on the beam member 14B. The three positioning pins 30 are disposed at positions corresponding to apexes of a triangle, to protrude above the base 15. The three positioning pins 30 protrude in the Z direction. The three positioning pins 30 support the container F to be purged. The positioning pin 30 is also called a kinematic pin.

The beam members 14A and 14B, the bases 15, and the positioning pins 30 constitute a plurality (four in FIGS. 1 and 2) of loading sections 7 on which the containers F are placed. The bottom face Fa of the container F is provided with recessed portions 51 (refer to FIG. 6), for example, to receive the positioning pins 30. The positioning pin 30 has a cylindrical shape having a diameter following a defined standard and vertically stands on the base 15. The recessed portion 51 is a groove portion having a width slightly larger than the diameter of the positioning pin 30. The container F is placed on a predetermined position on a loading surface 7a of the storage rack 1 by these positioning mechanisms. The loading section 7 is configured such that the container F can be horizontally placed on the loading section 7. Specifically, the three positioning pins 30 set at the same height position enter the three recessed portions 51 formed at the same height position to have the same depth and the same shape in the bottom face Fa of the container F, and each positioning pin 30 contacts near a bottom wall surface (wall surface formed at an upper end) of the recessed portion 51. As a result, the container F is supported by the three positioning pins 30, to have a horizontal posture.

The components according to the above loading sections 7, in other words, the beam members 14A and 14B, the bases 15, and the positioning pins 30 are components included in the storage rack 1 in the present embodiment, and also components included in the storage rack 1B illustrated in FIG. 5. In other words, the beam members 14A and 14B, the bases 15, and the positioning pins 30 are common components before and after the purging function is added. As illustrated in FIG. 5, in the storage rack 1B, the positioning pins 30 are fastened and fixed by screws 31 with root portions 30a of the positioning pins 30 located over three mounting holes 15a formed in the base 15. A gap G having a certain width (height) of approximately 5 mm to 20 mm in the Z direction, for example, exists between the bottom face Fa of the container F supported by the positioning pins 30 and the base 15. The purge device 20 in the present embodiment is attached, for example, by using this gap G.

With reference to FIGS. 1, 2, 3, 4, and 6, the storage rack 1 including the purge device 20 in the present embodiment is then described in detail. As illustrated in FIG. 2, four units of the purge devices 20 are attached in one storage rack 1. As illustrated in FIGS. 1, 2, 3, and 4, each purge device 20 has the base 15 described above, a nozzle unit 22 attached to the base 15, gas distribution piping 8a that branches off from the gas supply piping 8 and is connected to the nozzle unit 22, and a gas control device 21 installed at a branch portion of the gas distribution piping 8a. In FIG. 2, the nozzle unit 22 is illustrated in a simplified form.

As illustrated in FIG. 1, for example, one gas supply piping 8 is laid for one storage rack 1, and from the one gas supply piping 8, four pieces of the gas distribution piping 8a corresponding to the four loading sections 7 (purge device 20) branch off. The gas control device 21 has a housing of a rectangular shape and is attached at an appropriate position on the storage rack 1. The gas control device 21 has a flow controller, a control board, a regulator, a solenoid valve, and the like (all not illustrated). One unit of the gas control device 21 handles the four nozzle units 22. The gas control device 21 receives signals from a seating sensor 29, which will be described later, and detects presence and absence of the container F in each of the loading sections 7 of the storage rack 1. The gas control device 21 performs gas supply control to supply purge gas to the loading section 7 (container F) that requires supply of the purge gas according to storage conditions of one or a plurality of the containers F in the storage rack 1.

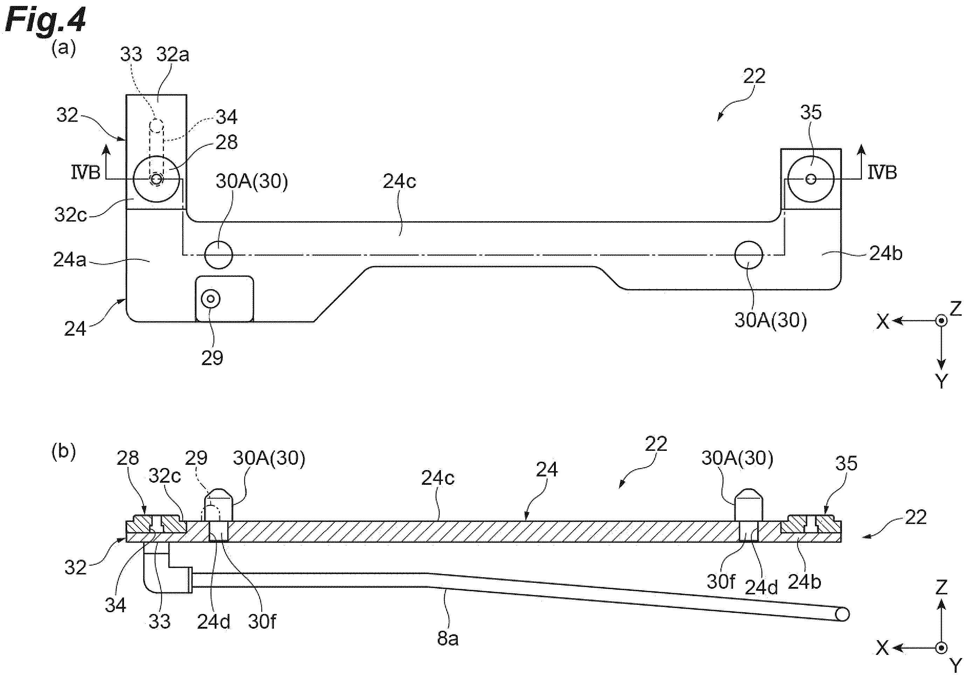

As illustrated in FIGS. 3 and 4, the nozzle unit 22 has a main body portion 24 attached on the base 15 and a gas introduction portion 32 coupled to a first end 24a of the main body portion 24 in the X direction. The main body portion 24 is provided with two positioning pins 30A and 30A and a seating sensor 29. The positioning pins 30A and 30A are a kind of the positioning pins 30 described above. The positioning pins 30A and 30A, for example, are designed specifically to fit the purge device 20, have a size equal to the positioning pin 30 of the storage rack 1B illustrated in FIG. 5, and are disposed in the same location. The positioning pins 30A and 30A are also used as fixtures for attaching the nozzle unit 22. The term "size of the positioning pin" is meant to include a diameter of a cylindrical head (tip portion) that enters the recessed portion 51. The term "position of the positioning pin" means not only a height position but also a spatial position (coordinates in XYZ three-dimensional space). As illustrated in FIG. 2, the storage rack 1 includes one piece of the positioning pin 30 located on the beam member 14B (positioning pin 30 of the storage rack 1B) and the two positioning pins 30A and 30A located on the beam member 14A and attached with the installation of the purge device 20.

As illustrated in FIG. 3, when the container F is stored, a lid Fb of the container F is close to the beam member 14A. In other words, the two positioning pins 30A and 30A are disposed on the lid Fb side of the container F in the Y direction.

The main body portion 24 includes a flat plate member disposed between the bottom face Fa of the container F supported by the positioning pin 30 and the positioning pins 30A and 30A and the base 15. The main body portion 24 has a thickness smaller than the height of the gap G, for example, to fit within the gap G (refer to FIG. 5). The main body portion 24 may have a certain thickness, for example. A seating sensor 29 is provided at the first end 24a of the main body portion 24 of a long size extending in the X direction. The seating sensor 29 is disposed at a position that is close to the one positioning pin 30A. As illustrated in FIG. 3, the seating sensor 29 is provided on a center side (farther side from the lid Fb) of the bottom face Fa than the one positioning pin 30A is, with the position of the container F as a reference.

In the nozzle unit 22, the gas introduction portion 32 is integrated into the main body portion 24. For example, the gas introduction portion 32 includes the flat plate member. The gas introduction portion 32 is integrated into the main body portion 24. The thickness of the gas introduction portion 32 is equal to the thickness of the main body portion 24, for example. The main body portion 24 and the gas introduction portion 32 extend horizontally when placed on the base 15. The gas introduction portion 32 may be attached and fixed to the first end 24a of the main body portion 24, or the main body portion 24 and the gas introduction portion 32 may be originally an integral plate member. As illustrated in FIG. 4(b), a top surface 32c of the gas introduction portion 32 is flush with a top surface 24c of the main body portion 24. Regarding members for forming the main body portion 24 and the gas introduction portion 32, design may be performed as appropriate considering that the main body portion 24 and the gas introduction portion 32 are disposed within the gap G.

As illustrated in FIGS. 3 and 4(a), the gas introduction portion 32 is provided with a nozzle 28 and a gas connection opening 33. Specifically, an end 32a of the gas introduction portion 32 extending in the Y direction protrudes outside the beam member 14A (that is, outside the base 15), and the gas connection opening 33 is formed on the underside of this end 32a. The nozzle 28 that is flat is attached to the gas introduction portion 32 so as to protrude slightly from the top surface 32c. A surface of the nozzle 28 extends horizontally. In the gas introduction portion 32, a gas inlet path 34 is formed that is configured to connect the gas connection opening 33 to the nozzle 28 to circulate purge gas. The gas inlet path 34 may be formed, for example, by configuring the gas introduction portion 32 from two members and aligning the grooves provided in the respective members. The gas inlet path 34 extends in the Y direction, for example. As illustrated in FIG. 4(b), the gas distribution piping 8a is connected to the gas connection opening 33.

Although not actually used in the purge device 20 of the storage rack 1, a second end 24b of the main body portion 24 is provided with a discharge nozzle 35 for discharging purge gas. When an outlet of a purge gas is provided at the bottom face Fa of the container F, the outlet is connected to the discharge nozzle 35. Sampling of gas or measurement of gas flow or the like may be performed with the outlet connected to the discharge nozzle 35.

In the nozzle unit 22, the nozzle 28 (and the discharge nozzle 35) is disposed and fixed in a predetermined position with respect to the two positioning pins 30A and 30A. A spatial position (coordinates in XYZ three-dimensional space) of the nozzle 28 (and the discharge nozzle 35) is strictly set with respect to the two positioning pins 30A and 30A. Positions of the two positioning pins 30A and 30A used for the attachment of the nozzle unit 22, the one positioning pin 30 disposed outside the nozzle unit 22, and the nozzle 28 are defined to fit the respective parts of the bottom face Fa of the container F (three recessed portions 51 and one gas inlet 52). The head (tip portion) of each of the one positioning pin 30 and the two positioning pins 30A and 30A has a size that allows the head to enter the corresponding recessed portion 51.

As illustrated in FIG. 6, the main body portion 24 has two pin insertion holes 24d at positions overlapping the two mounting holes 15a in the base 15. With the nozzle unit 22 placed on the base 15 and the pin insertion hole 24d overlapping each of the two mounting holes 15a, a root portion 30f of the positioning pin 30A is inserted, and the positioning pin 30A is fastened and fixed by a screw 31f. The root portion 30f of the positioning pin 30A has a cylindrical shape and is concentric with the head described above. The diameter of the root portion 30f of the positioning pin 30A is smaller than the diameter of the head, for example (refer also to FIG. 4(b)). The diameter of the pin insertion hole 24d is set such that the root portion 30f of the positioning pin 30A can be inserted into the pin insertion hole 24d. The screw 31f fixes the main body portion 24 to the base 15. The screw 31f and the screw 31 for fixing the positioning pin 30 may be common members, or the screw 31f may be a dedicated member different from the screw 31. The screw 31f of the positioning pin 30A may be thinner than the root portion 30a of the positioning pin 30. The positions of center axes and the height positions of the two positioning pins 30A and 30A illustrated in FIG. 6 are equal to the positions of center shafts and the height positions of the two positioning pins 30 and 30 illustrated in FIG. 5 (before the addition of the purge function). In other words, the positions (axes) and the arrangement of the three positioning pins 30 remain unchanged before and after the addition of the purge function. The positions of the three mounting holes 15a formed in the base 15 define the positions (axes) of the three positioning pins 30. Therefore, the position of the container F supported by the three positioning pins 30, illustrated in FIG. 5, and the position of the container F supported by the one positioning pin 30 and the two positioning pins 30A and 30A, illustrated in FIG. 6, are identical (unchanged). In FIG. 6, the one positioning pin 30 is located closer to a front side in the paper than the main body portion 24 is.

In the purge device 20, the main body portion 24 is attached on the base 15 via the two positioning pins 30A and 30A. The two mounting holes 15A illustrated in FIG. 5 are also used for the attachment of the nozzle unit 22, so that the positions of the two positioning pins 30A and 30A are unchanged. Furthermore, in the nozzle unit 22, positioning of the nozzle 28 with respect to the two positioning pins 30A and 30A is also performed. In a state illustrated in FIG. 6, the nozzle 28 of the purge device 20 comes to close contact with the gas inlet 52 formed on the bottom face of the container F and is connected to the gas inlet 52 so that purge gas can be supplied to the container F supported by the positioning pin 30.

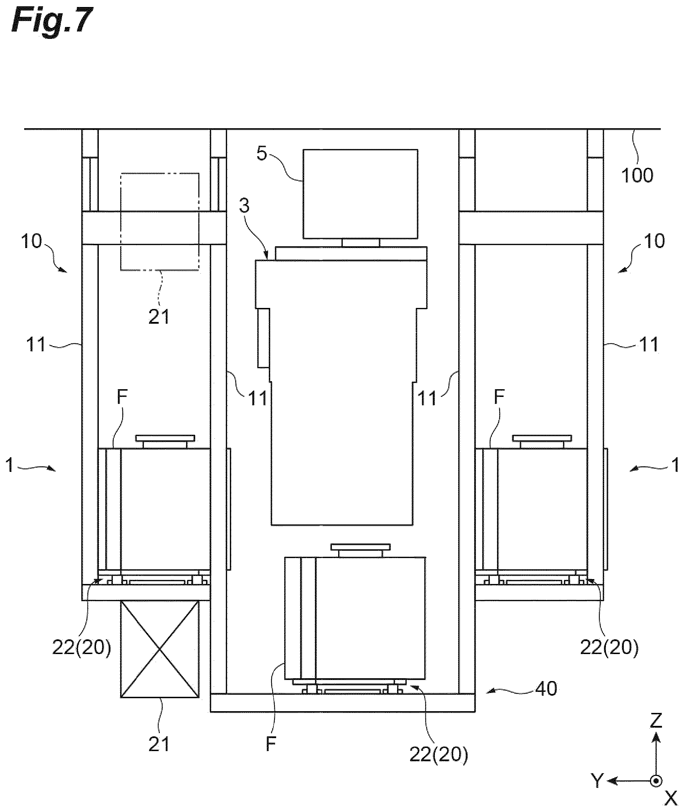

Referring now to FIG. 7, the arrangement of the gas control device 21 is described. As illustrated in FIG. 7, when the storage rack 1 includes a storage rack 40 (under-track buffer; UTB) disposed below the track 5, the gas control device 21 may be stored in a step portion formed between storage rack 40 and the storage rack 1. In this case, the space between the storage rack 40 and the storage rack 1 can be used effectively, and the gas distribution piping 8a and the gas connection opening 33 can be easily connected together. The gas control device 21 can be installed, for example, using a groove in the supporting section 11 (column). As illustrated by a virtual line in FIG. 7, the gas control device 21 may be installed above the storage rack 1 (between the loading section 7 and the ceiling 100).

A modification method for adding a purge function to the storage rack 1B having no purge function is then described. First, with respect to the storage rack 1B illustrated in FIG. 5, the two positioning pins 30 and 30 (existing positioning pins) are removed that are close to the beam member 14A (that is, disposed on the lid Fb side of the container F). The nozzle unit 22 is then placed on the base 15. With the pin insertion hole 24d of the main body portion 24 overlapping the mounting hole 15a of the base 15, the root portion 30f of the positioning pin 30A is inserted into the pin insertion hole 24d and the mounting hole 15a, and the positioning pin 30A is fastened and fixed with the screw 31f. As a result, the nozzle unit 22 is fixed to the base 15. Then, the gas distribution piping 8a is connected to the gas connection opening 33 of the gas introduction portion 32. The gas distribution piping 8a is disposed outside of the base 15 in the Y direction, and the gas connection opening 33 is located outside of the base 15. Therefore, the gas distribution piping 8a can be laid and connected without hindrance. No modification of the base 15 is required.

With the purge device 20, the main body portion 24 is attached on the base 15 and the container F is positioned and supported by the positioning pins 30, 30A, and 30A. The gas introduction portion 32 is coupled to the main body portion 24, and the planar position of the nozzle 28 with respect to the positioning pins 30A and 30A (position in the XY plane) is set to fit the position of the gas inlet 52 or the like on the bottom face Fa of the container F. As a result, the nozzle 28 of the gas introduction portion 32 is connected to the gas inlet 52 of the container F, and purge gas is supplied into the inside of the container F through the nozzle 28. Teaching about the positioning pins 30, 30A, and 30A is performed for the overhead transport vehicle 3. Once teaching is performed, the positions of the positioning pins 30, 30A, and 30A do not change as long as the base 15 is used, even if the nozzle unit 22 is replaced for nozzle replacement or other reasons after the teaching. Therefore, teaching is not required again. As a result, the time and effort for teaching to the overhead transport vehicle 3 can be reduced. This effect can be also exerted at other times than the replacement of the nozzle unit 22. As described above, the same effect as above is exerted when the purge function is added to the storage rack 1B having no purge function. When the nozzle unit 22 is installed, the main body portion 24 is attached onto the base 15 via the positioning pins 30A and 30A, and thus the positions of the positioning pins 30A and 30A do not change before and after the purging function is added. Therefore, teaching is not required again when the purge device 20 is retrofitted.

The main body portion 24 includes a flat plate member disposed in the gap G between the bottom face Fa of the container F supported by the positioning pins 30, 30A, and 30A and the base 15. The space (gap G) existing between the bottom face Fa of the container F and the base 15 can be used to dispose the main body portion 24.

The gas introduction portion 32 is integrated into the main body portion 24, and the nozzle 28 is disposed and fixed in a predetermined position with respect to the positioning pins 30A and 30A. Installation of the nozzle unit 22 is completed by simply attaching the main body portion 24 to the base 15. The nozzle unit 22 can be easily installed and the configuration of the nozzle unit 22 is simple.

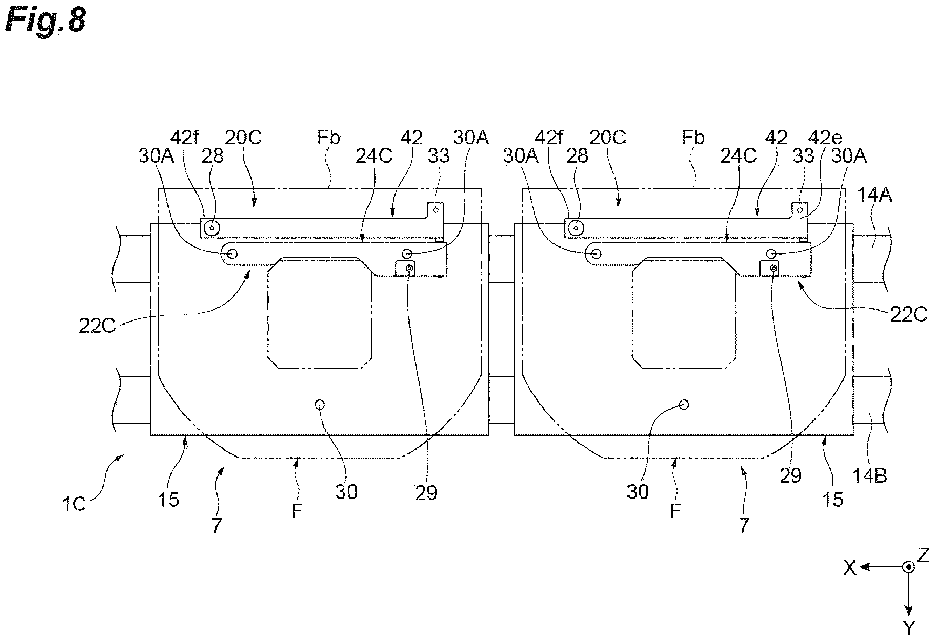

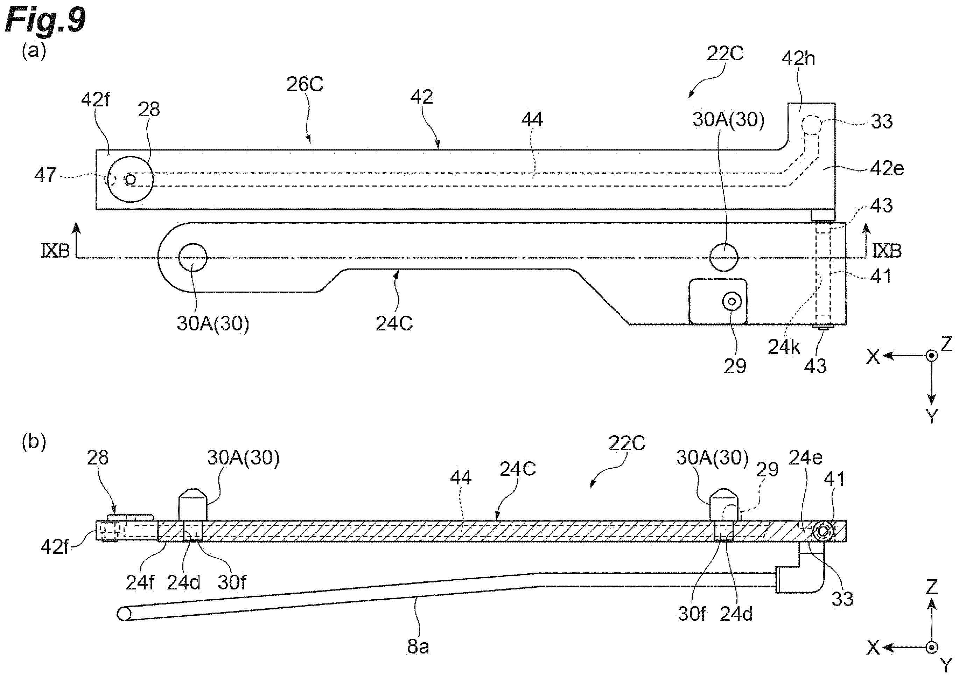

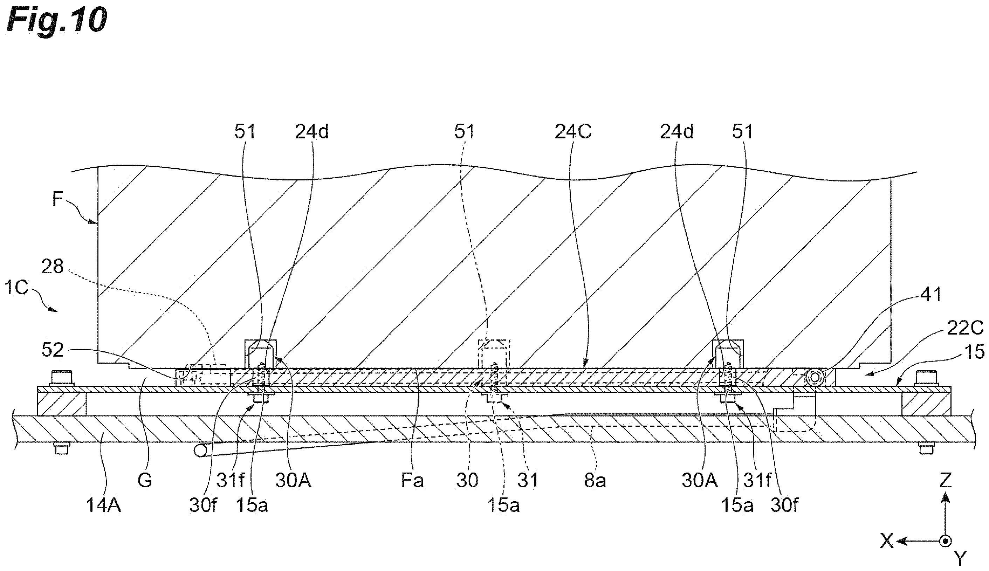

With reference to FIGS. 8 to 12, the purge device 20C according to the second embodiment is then described. The storage rack 1C on which the purge device 20C is installed differs from the storage rack 1 of the above embodiment in that the nozzle unit 22C having a different configuration from the nozzle unit 22 of the purge device 20 is provided. The nozzle unit 22C has a main body portion 24C and a gas introduction portion 26C (refer to FIG. 9(a)). The container F stored on the storage rack 1C, illustrated in FIG. 10, is in the same position and has the same posture as the container F stored on the storage rack 1, illustrated in FIG. 6. In other words, in the purge device 20C, the configuration of the positioning pins 30A and 30A included in the main body portion 24C is identical to that in the main body portion 24 of the purge device 20.

As illustrated in FIG. 8 and FIG. 9(a), the purge device 20C has the main body portion 24C that is attached on the base 15 via the positioning pins 30A and 30A, and the gas introduction portion 26C that is coupled to the main body portion 24C and provided with the nozzle 28. The main body portion 24C includes a flat plate member disposed between the bottom face Fa of the container F supported by the positioning pin 30 and the positioning pins 30A and 30A, and the base 15.

In the nozzle unit 22C, similarly to the nozzle unit 22, the main body portion 24C is fixed to the base 15 using the positioning pins 30A and 30A. On the other hand, the gas introduction portion 26C is separate from the main body portion 24C.

The gas introduction portion 26C includes a rotary arm 42 coupled to the main body portion 24C via a rotary shaft 41 (horizontally) disposed in the Y direction. The rotary arm 42 is, for example, a long flat plate member extending in the X direction. The thickness of the rotary arm 42 is equal to the thickness of the main body portion 24C, for example. At a first end 24e in the X direction of the main body portion 24, the rotary shaft 41 is provided, and the rotary arm 42 can rotate (swing) around the rotary shaft 41. More precisely, the main body portion 24C has a shaft hole 24k extending in the Y direction formed at the first end 24e, and the rotary shaft 41 is inserted through the shaft hole 24k. A first end 42e (base end portion) of the rotary arm 42 is fixed to one end of the rotary shaft 41 such that the main body portion 24C and the rotary arm 42 extend parallel in the X direction. In other words, the rotary shaft 41 is provided at the first end 42e of the rotary arm 42. The rotary shaft 41 is supported by bushings 43 and 43 provided at both ends and inserted into the shaft hole 24k, and can freely rotate within the shaft hole 24k. With the above configuration, the rotary arm 42 is rotatably coupled to the main body portion 24C. The rotary shaft 41, the shaft hole 24k and the bushings 43 and 43 constitute a pivot section. The configuration in which the rotary arm 42 is rotatably coupled to the main body portion 24C (configuration of the pivot section) is not limited to the above, and various other configurations may be employed.

In the nozzle unit 22C, the seating sensor 29 is provided near the first end 24e of the main body portion 24C (in an area close to the rotary shaft 41). The seating sensor 29 is disposed at a position that is close to the one positioning pin 30A. As illustrated in FIG. 8, the seating sensor 29 is provided on a center side (farther side from the lid Fb) of the bottom face Fa than the one positioning pin 30A is, with the position of the container F as a reference.

As illustrated in FIGS. 9(a) and 9(b), the gas introduction portion 26C is provided with the nozzle 28 and the gas connection opening 33. The gas connection opening 33 is formed on the underside of the first end 42e of the rotary arm 42. The gas distribution piping 8a is connected to the gas connection opening 33. Specifically, the first end 42e of the rotary arm 42 extends in the Y direction and protrudes outside the beam member 14A (that is, outside the base 15) (refer to FIG. 8), and the gas connection opening 33 is formed on the underside of the protrusion, that is, a protruding portion 42h. A second end 42f on a side opposite to the first end 42e of the rotary arm 42 protrudes in the X direction from a second end 24f of the main body portion 24C. The flat nozzle 28 is attached to the second end 42f. In the rotary arm 42, a gas inlet path 44 is formed that is configured to connect the gas connection opening 33 to the nozzle 28 to circulate purge gas. The gas inlet path 44 may be formed, for example, by stacking the two rotary arms 42 in the Z direction, and aligning the grooves provided in the respective rotary arms 42. The gas inlet path 44, for example, has a length corresponding to the total length of the rotary arm 42 and extends in the X direction.

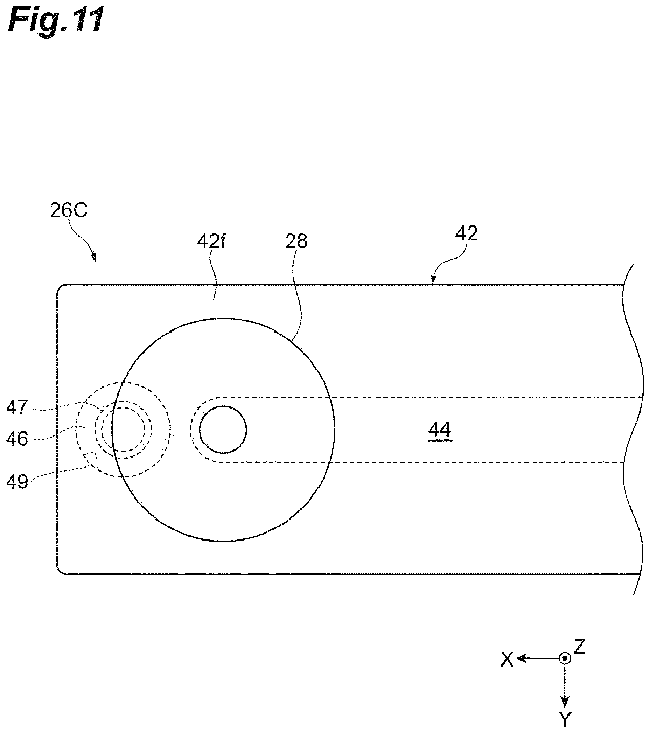

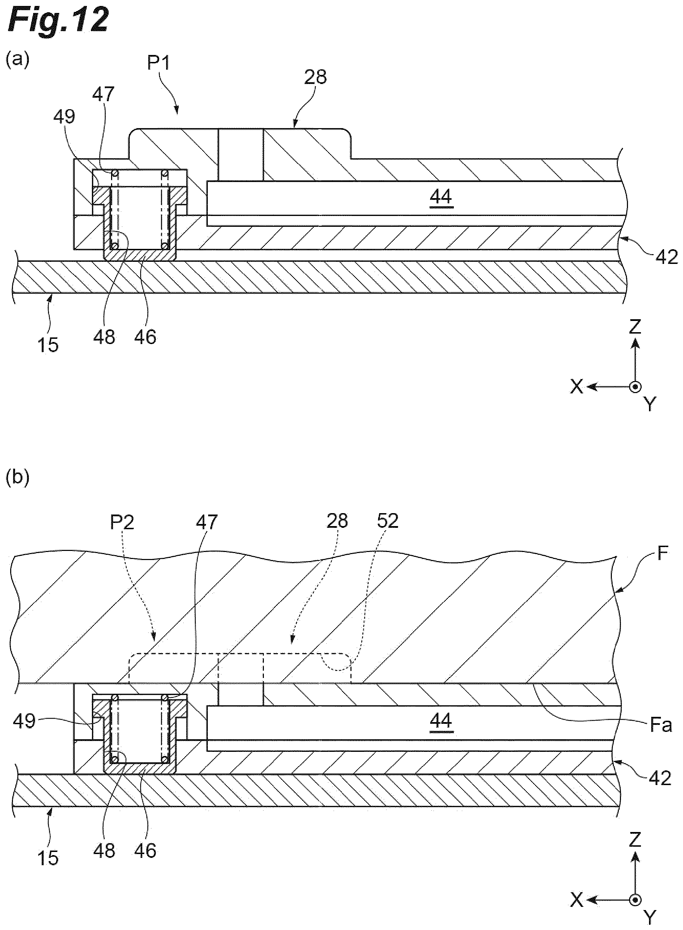

As illustrated in FIGS. 11 and 12(a), a bushing 46 and a spring (elastic member) 47 are disposed below the nozzle 28 and between the nozzle 28 and the base 15, around an axis extending in the Z direction. An upper part of the bushing 46 is housed in a bushing housing hole 49 of a cylindrical shape formed in the Z direction in the second end 42f, and the lower part of the bushing 46 is inserted into a bushing insertion hole 48 of a cylindrical form formed in the Z direction. A spring 47 is fitted inside the bushing 46. The bushing 46 holds the spring 47. The lower end of the spring 47 contacts the bushing 46, and the upper end of the spring 47 contacts a back side of the nozzle 28. The spring 47 supports the nozzle 28. The nozzle 28 is energized upward by the spring 47. Since the rotary arm 42 can rotate around the rotary shaft 41, the nozzle 28 is movable up and down while being supported by the spring 47. A movable range of the nozzle 28 is, for example, about several millimeters.

In the nozzle unit 22C, the nozzle 28 is also disposed in a predetermined position with respect to the two positioning pins 30A and 30A. Since the nozzle 28 is movable up and down, the position (height) of the nozzle 28 in the Z direction is variable. However, when the nozzle 28 is in a state of being supported by the spring 47 (with the second end 42f of the rotary arm 42 being on the spring 47), the position of the nozzle 28 in the X and Y directions is set to a desired position with respect to the two positioning pins 30A and 30A. The positions of the two positioning pins 30A and 30A used for the attachment of the nozzle unit 22C, the one positioning pin 30 disposed outside the nozzle unit 22, and the nozzle 28 are defined to fit the corresponding parts of the bottom face Fa of the container F (the three recessed portions 51 and the one gas inlet 52).

A modification method for adding a purge function to the storage rack 1B having no purge function is then described. First, with respect to the storage rack 1B illustrated in FIG. 5, the two positioning pins 30 and 30 (existing positioning pins) are removed that are close to the beam member 14A (that is, disposed on the lid Fb side of the container F). Next, the nozzle unit 22C is placed on the base 15. With the pin insertion hole 24d of the main body portion 24C overlapping the mounting hole 15a of the base 15, the root portion 30f of the positioning pin 30A is inserted into the pin insertion hole 24d and the mounting hole 15a, and the positioning pin 30A is fastened and fixed with the screw 31f. Furthermore, the rotary arm 42 is placed on the base 15 in a posture in which the second end 42f is placed on the spring 47 on the base 15. As a result, the nozzle unit 22 is fixed to the base 15. Then, the gas distribution piping 8a is connected to the gas connection opening 33 of the gas introduction portion 32. The gas distribution piping 8a is disposed outside of the base 15 in the Y direction, and the gas connection opening 33 is located outside of the base 15. Therefore, the gas distribution piping 8a can be laid and connected without hindrance. No modification of the base 15 is required.

As illustrated in FIG. 12(a), before the container F is placed on the positioning pins 30, 30A, and 30A, the nozzle 28 is energized by the spring 47 and located at an initial position P1 that is slightly elevated. As illustrated in FIG. 8 and FIG. 12(b), when the container F is placed on the positioning pins 30, 30A, and 30A, the rotary arm 42 and nozzle 28 are pushed downward by the weight of the container F, come to close contact with the gas inlet 52, and are located on the operating position P2. In this state, the main body portion 24C and the rotary arm 42 rotate to the same height as the main body portion 24C and extend substantially horizontally.

With the purge device 20C with the nozzle unit 22C also, the time and effort for teaching to the overhead transport vehicle 3 can be reduced. Teaching is not required again when the purge device 20C is retrofitted. The space (gap G) existing between the bottom face Fa of the container F and the base 15 can be used to dispose the main body portion 24C. In addition because the nozzle 28 is movable, the adjustment of the position of the nozzle 28 in the height direction can be eliminated.

The distance from the rotary shaft 41 to the nozzle 28 corresponds to the length of the rotary arm 42. The gas distribution piping 8a for circulating purge gas is connected to the nozzle 28 via the gas connection opening 33. In the nozzle unit 22C, a long distance is secured from the rotary shaft 41 to the nozzle 28. Increasing this distance can reduce the effect on the piping caused by the rotation of the rotary arm 42 (that is, the up and down movement of the nozzle 28). For example, when the movable range (stroke) of the nozzle 28 is set to a constant value, as the distance from the rotary shaft 41 to the nozzle 28 becomes longer, the rotation angle of rotation of the rotary arm 42 becomes smaller. This mechanism can be self-evidently understood when the rotary arm 42 is regarded as a radius and a range of up and down movement of the nozzle 28 is regarded as a length of a circumference. Moreover, the gas distribution piping 8a is disposed in a different position from the beam member 14a and the base 15, thereby avoiding interference with the beam member 14a and the base 15. Thus, the up and down movement of the 28 nozzles is not obstructed.

The embodiments of the present invention have been described as above, but the present invention is not limited thereto. For example, the above embodiments describe a case in which the nozzle unit 22 is attached via the two positioning pins 30A and 30A, but unlike this configuration, the nozzle unit 22 may be attached via the one positioning pin 30A. In such cases, a position regulating member is separately provided in the nozzle unit 22 to determine a position of the nozzle unit 22 in a rotation position. Examples of the position regulating member include a member configured to engage or contact part of the container placing stand, for example, such as a beam member. The nozzle unit 22 of the purge device 20 is attached to the beam member (14A or 14B) on which one of the three positioning pins 30 is disposed. Even in such a case, the positions and the arrangement of the three positioning pins 30 remain unchanged before and after the addition of the purge function. With the configuration in which the nozzle unit 22 is attached via the two positioning pins 30A and 30A (fixtures) as in the above embodiments, the position of the nozzle unit 22 in the rotation direction is determined (fixed) by the positioning pins 30A and 30A only.

In the purge device of the present disclosure, the positions of the at least one of the positioning pins 30A and 30A used for the attachment of the nozzle unit, other positioning pins 30 disposed outside the nozzle unit, and the nozzle are defined to fit the respective parts of the container (a plurality of recessed portions and a gas inlet and/or outlet). If the nozzle unit is attached via only one positioning pin 30A, another position regulating member is provided. When the nozzle unit is attached via the two or three positioning pins 30A, those positioning pins 30A also serve as position regulating means for the nozzle unit, and another position regulating member is not required. When the nozzle unit is attached via the three positioning pins 30A, the other positioning pins 30 disposed outside the nozzle unit can be omitted. The positioning pin 30A does not have to be dedicatedly designed. The positioning pin provided in the nozzle unit may be identical to other positioning pins 30 disposed outside the nozzle unit.

The spring 47 in the nozzle unit 22C of the second embodiment may be replaced by other elastic members. An elastic member, for example made of rubber or sponge, may be provided on the underside of the nozzle 28. In the second embodiment, the rotary shaft 41 may be provided at a portion other than the first end 24e.

The purge device and the nozzle unit of the present disclosure may be applied to conveyance devices other than the overhead transport vehicles.

### Reference Signs List

1, 1C ... storage rack
3 ... overhead transport vehicle
5 ... track
7 ... loading section
10 ... base frame
14A, 14B ... beam member
15 ... base
20, 20C ... purge device
21 ... gas control device
22, 22C ... nozzle unit
24, 24C ... main body portion
26C ... gas introduction portion
28 ... nozzle
29 ... seating sensor
30 ... positioning pin
30A ... positioning pin (for attachment of the nozzle unit)
32 ... gas introduction portion
40 ... storage rack
41 ... rotary shaft
42 ... rotary arm
42e ... first end
42f ... second end
43 ... bushing
46 ... bushing
47 ... spring (elastic member)
51 ... recessed portion
52 ... gas inlet
100 ... ceiling
S ... semiconductor transfer system

## Claims

1. A purge device (20, 20C) including a base (15) to which a positioning pin (30, 30A) configured to support a container (F) to be purged is attached, and a nozzle (28) configured to connect to a gas inlet (52) of the container (F) supported by the positioning pin (30, 30A), the purge device (20, 20C) comprising:
a nozzle unit (22, 22C) having a main body portion (24, 24C) attached to the base (15) via the positioning pin (30, 30A), and a gas introduction portion (32) coupled to the main body portion (24, 24C) and provided with the nozzle (28).

2. The purge device (20, 20C) according to claim 1, wherein the main body portion (24, 24C) includes a flat plate member disposed between a bottom face (Fa) of the container (F) supported by the positioning pin (30, 30A) and the base (15).

3. The purge device (20) according to claim 1 or 2, wherein the gas introduction portion (32) is integrated into the main body portion (24), and the nozzle (28) is disposed and fixed in a predetermined position with respect to the positioning pin (30, 30A).

4. The purge device (20C) according to claim 1 or 2, wherein the gas introduction portion (32) includes an elastic member (47) disposed on an underside of the nozzle (28) to support the nozzle (28), and the nozzle (28) is energized upward by the elastic member (47) and is movable up and down.

5. The purge device (20C) according to claim 4, wherein
the gas introduction portion (32) includes a rotary arm (42) that is coupled to the main body portion (24C) via a rotary shaft (41) horizontally disposed therebetween and configured to be rotatable with respect to the main body portion (24C), the rotary arm (42) including a first end (42e) provided with the rotary shaft (41) and a second end (42f) on a side opposite to the first end (42e), and
the nozzle (28) is provided at the second end (42f).

## Patentansprüche

1. Eine Spülvorrichtung (20, 20C), die eine Basis (15), an der ein Positionierstift (30, 30A) angebracht ist, der dazu konfiguriert ist, einen zu spülenden Behälter (F) zu tragen, und eine Düse (28) umfasst, die dazu konfiguriert ist, mit einem Gaseinlass (52) des Behälters (F) verbunden zu werden, der durch den Positionierstift (30, 30A) getragen wird, wobei die Spülvorrichtung (20, 20C) folgendes Merkmal aufweist:
eine Düseneinheit (22, 22C) mit einem Hauptkörperabschnitt (24, 24C), der über den Positionierstift (30, 30A) an der Basis (15) angebracht ist, und einem Gaseinleitungsabschnitt (32), der mit dem Hauptkörperabschnitt (24, 24C) gekoppelt ist und mit der Düse (28) bereitgestellt ist.

2. Die Spülvorrichtung (20, 20C) gemäß Anspruch 1, bei der der Hauptkörperabschnitt (24, 24C) ein flaches Plattenbauglied umfasst, das zwischen einer Bodenfläche (Fa) des Behälters (F), der durch den Positionierstift (30, 30A) getragen wird, und der Basis (15) angeordnet ist.

3. Die Spülvorrichtung (20) gemäß Anspruch 1 oder 2, bei der der Gaseinleitungsabschnitt (32) in den Hauptkörperabschnitt (24) integriert ist und die Düse (28) in einer vorbestimmten Position in Bezug auf den Positionierstift (30, 30A) angeordnet und fixiert ist.

4. Die Spülvorrichtung (20C) gemäß Anspruch 1 oder 2, bei der der Gaseinleitungsabschnitt (32) ein elastisches Bauglied (47) umfasst, das an einer Unterseite der Düse (28) angeordnet ist, um die Düse (28) zu tragen, und die Düse (28) durch das elastische Bauglied (47) nach oben mit Energie versorgt wird und auf und ab bewegbar ist.

5. Die Spülvorrichtung (20C) gemäß Anspruch 4, bei der
der Gaseinleitungsabschnitt (32) einen Dreharm (42) umfasst, der mit dem Hauptkörperabschnitt (24C) über eine Drehwelle (41) gekoppelt ist, die horizontal zwischen denselben angeordnet ist und dazu konfiguriert ist, in Bezug auf den Hauptkörperabschnitt (24C) drehbar zu sein, wobei der Dreharm (42) ein erstes Ende (42e), das mit der Drehwelle (41) bereitgestellt ist, und ein zweites Ende (42f) an einer dem ersten Ende (42e) gegenüberliegenden Seite umfasst, und
die Düse (28) an dem zweiten Ende (42f) bereitgestellt ist.

## Revendications

1. Dispositif de purge (20, 20C) comprenant une base (15) à laquelle est fixée une broche de positionnement (30, 30A) configurée pour supporter un récipient (F) à purger, et une buse (28) configurée pour se connecter à une entrée de gaz (52) du récipient (F) supporté par la broche de positionnement (30, 30A), le dispositif de purge (20, 20C) comprenant :
une unité de buse (22, 22C) comportant une partie de corps principal (24, 24C) fixée à la base (15) via la broche de positionnement (30, 30A), et une partie d'introduction de gaz (32) couplée à la partie de corps principal (24, 24C) et pourvue de la buse (28).

2. Dispositif de purge (20, 20C) selon la revendication 1, dans lequel la partie de corps principal (24, 24C) comprend un élément plat disposé entre une face inférieure (Fa) du récipient (F) supporté par la broche de positionnement (30, 30A) et la base (15).

3. Dispositif de purge (20) selon la revendication 1 ou 2, dans lequel la partie d'introduction de gaz (32) est intégrée dans la partie de corps principal (24), et la buse (28) est disposée et fixée dans une position prédéterminée par rapport à la broche de positionnement (30, 30A).

4. Dispositif de purge (20C) selon la revendication 1 ou 2, dans lequel la partie d'introduction de gaz (32) comprend un élément élastique (47) disposé sur une face inférieure de la buse (28) pour supporter la buse (28), et la buse (28) est sollicitée vers le haut par l'élément élastique (47) et est mobile vers le haut et vers le bas.

5. Dispositif de purge (20C) selon la revendication 4, dans lequel la partie d'introduction de gaz (32) comprend un bras rotatif (42) qui est couplé à la partie de corps principal (24C) via un arbre rotatif (41) disposé horizontalement entre eux et configuré pour pouvoir tourner par rapport à la partie de corps principal (24C), le bras rotatif (42) comprenant une première extrémité (42e) pourvue de l'arbre rotatif (41) et une deuxième extrémité (42f) sur un côté opposé à la première extrémité (42e), et
la buse (28) est pourvue au niveau de la deuxième extrémité (42f).
